# EUROPEAN PATENT APPLICATION

(11) **EP 4 401 312 A2**
(43) Date of publication of application: **17.07.2024**
(21) Application number: 23219840.8
(22) Date of filing: 22.12.2023
(51) Int. Cl.: H03K 7/08

(54) **CONTROL-SIGNAL GENERATION MODULE AND METHOD**

(30) Priority: 30.12.2022 CN 202211725222
(71) Applicant: Huada Semiconductor Co., Ltd., Pudong New Area, Shanghai 201203 (CN)
(72) Inventor: XIE, Wei, Shanghai, 201203 (CN); QIAO, Kai, Shanghai, 201203 (CN); LIU, Bin, Shanghai, 201203 (CN)
(74) Representative: Canzler & Bergmeier Patentanwälte Partnerschaft mbB

(57) **Abstract**

A control-signal generation module is provided, comprising an edge-triggering first actuation module, a level-triggering second actuation module, and a signal processing module disposed between the first and second actuation modules. The first actuation module changes its output signal in accordance with first preset information upon receiving a valid edge of asynchronous events that have been synchronized. The second actuation module changes its output signals in accordance with second preset information upon receiving a valid level of the asynchronous events, and outputs signals generated by the signal processing module when detecting disappearance of the valid level of the asynchronous events. The signal processing module is for processing and outputting the signal generated by the first actuation module in accordance with preset configuration information. These modules can achieve high precision SET and CLEAR, and finally obtain a high-precision control signal.

## Description

### CROSS REFERENCE TO RELATED APPLICATION

The present application claims the benefit of priority to Chinese Patent Application No. CN 202211725222.0, entitled "CONTROL-SIGNAL GENERATION MODULE AND METHOD", filed with CNIPA on December 30, 2022, the disclosure of which is incorporated herein by reference in its entirety for all purposes.

### FIELD OF THE INVENTION

The present disclosure generally relates to pulse width modulation (PWM) technology, and in particular to a control-signal generation module and method.

### BACKGROUND OF THE INVENTION

PWM technology controls output voltages by adjusting pulse widths of PWM output signals, which is mainly achieved by controlling the on-and-off of switching transistors to produce a series of square-wave signals. The on-and-off of the switching transistors can be controlled through asynchronous events. However, current technology can only achieve immediate driving CLEAR using asynchronous events in order to obtain high-precision CLEAR. But it cannot achieve high-precision SET, leaving room for improvement in the control accuracy of PWM output signals.

### SUMMARY OF THE INVENTION

In view of some or all of the problems in existing technology, in order to improve the control accuracy of PWM output signals and reduce control errors, the present disclosure provides a control-signal generation module in the first aspect, which can achieve high-precision CLEAR and/or SET. The control-signal generation module comprises: a first actuation module, which is edge-triggering and configured to change its output signal in accordance with first preset information upon receiving a valid edge of asynchronous events that have been synchronized (that is, synchronized with a clock); a second actuation module, which is level-triggering and configured to change its output signals in accordance with second preset information upon receiving a valid level of the asynchronous events; and a signal processing module, whose input terminal is connected to an output terminal of the first actuation module and whose output terminal is connected to an input terminal of the second actuation module, wherein the signal processing module is configured to process the output signal of the first actuation module according to preset configuration information and output the processed output signal, wherein when the second actuation module no longer receives the valid level of the asynchronous events, the second actuation module outputs signals generated by the signal processing module.

Further, the signal processing module comprises a delay sub-module configured to determine an actual delay Dcur based on a preset delay Dpre, and to delay a rising edge or a falling edge of the output signal of the first actuation module by a length of the actual delay Dcur, and to generate corresponding PWM signals, wherein Dcur=Dpre-Dsyn, wherein Dsyn is a synchronization delay due to synchronization of the asynchronous events, and is smaller than or equal to the preset delay.

Further, the signal processing module is configured to directly output the output signal of the first actuation module without processing.

Further, the signal processing module further comprises an inverting sub-module configured to invert an output signal of the delay sub-module according to preset inverting information and to generate the corresponding PWM signals.

Further, the asynchronous events have a valid level length greater than or equal to the length of time between a starting point of the asynchronous events and a time point when the signal processing module starts outputting updated signals.

Further, the generation module comprises a synchronization module configured to synchronize the asynchronous events and then output them to the first actuation module.

Further, the first actuation module is configured to generate at least one path of PWM signal; and a path quantity of PWM signals generated by the second actuation module is equal to that of the signal processing module, and is not less than that of the first actuation module.

Based on the generation module described above, the present disclosure further provides a control-signal generation method with delay operations, comprising: synchronizing asynchronous events by a synchronization module to obtain synchronized asynchronous events, then sending the synchronized asynchronous events to a first actuation module, and recording a synchronization delay due to the synchronization; generating a first PWM signal by the first actuation module in accordance with first preset information when the first actuation module receives a valid edge signal of the synchronized asynchronous events; sending the first PWM signal generated by the first actuation module to a signal processing module, and generating updated PWM signals by the signal processing module according to preset configuration information of the signal processing module, wherein the signal processing module comprises a delay sub-module, wherein the delay sub-module is configured to delay the PWM signal generated by the first actuation module by a length of an actual delay, wherein the actual delay is determined according to a preset delay and the synchronization delay; and sending the updated PWM signals generated by the signal processing module to the second actuation module, and the second actuation module directly outputs, the updated PWM signals generated by the signal processing module unless an event occurs to the second actuation module that requires changing the updated PWM signals generated by the signal processing module.

Further, the actual delay is equal to a difference between the preset delay and the synchronization delay, wherein the preset delay is not smaller than the synchronization delay.

Based on the generation module described above, the present disclosure further provides another control-signal generation method with no delay operations, comprising: by a second actuation module, detecting the active-level of asynchronous events, and generating second PWM signals by the second actuation module in accordance with second preset information upon detecting a valid level of the asynchronous events; by a synchronization module, synchronizing the asynchronous events, and sending synchronized asynchronous events to a first actuation module; by the first actuation module, changing a PWM signal to be generated by the first actuation module in accordance with first preset information upon receiving a valid edge signal of the synchronized asynchronous events, and sending a PWM signal generated by the first actuation module to a signal processing module; by the signal processing module, processing the PWM signal generated by the first actuation module in accordance with preset configuration information and outputting the processed PWM signal; and by the second actuation module, outputting PWM signals generated by the signal processing module when detecting disappearance of the valid level of the asynchronous events.

Further, the asynchronous events have a valid level length greater than or equal to the length of time between a starting point of the asynchronous events and a time point when the signal processing module starts outputting the updated PWM signals that it generates.

Further, the generation method comprises: when PWM signals generated by the second actuation module have a constant level for a duration longer than a preset maximum on-time, triggering the first actuation module to change the status of its outputs, at which time the signal processing module acts in accordance with the preset configuration information to generate updated PWM signals, causing the second actuation module to generate corresponding PWM signals.

Further, the generation method comprises: ignoring valid events that occur during a period time whose length is equal to the preset minimum on/off time, which is counted from the time point when changes are detected in signals output by the second actuation module.

The present disclosure provides a control-signal generation module and method that, by means of a level-triggering second actuation module and an edge-triggering first actuation module together with a signal processing module, can generate a PWM driver that achieves high-precision SET with a rising-edge delay dead zone and high-precision CLEAR without a delay dead zone based on asynchronous events, or a PWM driver that achieves high-precision SET with a rising-edge dead zone based on asynchronous events and high-precision CLEAR based on synchronous events, or a PWM driver that achieves high-precision SET with a rising edge dead zone based on synchronous events and high-precision CLEAR without a delay dead zone based on asynchronous events, and finally obtain high-precision drive signals. The generation module and method can achieve high-precision drive pulses through asynchronous and/or synchronous event control, and highly integrate power conversion control, such as peak control and hysteresis control, which relies on asynchronous event control to achieve digitalization, thereby improving the accuracy of pulse width control, reducing control errors, and making it capable of adapting to the trend of higher system frequencies.

### BRIEF DESCRIPTION OF THE DRAWINGS

To further clarify the above and other advantages and features of the various embodiments of the present disclosure, reference will be made to the accompanying drawings to present a more specific description of the various embodiments of the present disclosure. It can be understood that these drawings only depict typical embodiments of the present disclosure and will not be considered as limiting its scope. In the drawings, for clarity, the same or corresponding parts will be indicated by the same or similar markings.
FIG. 1 is a block diagram of a control-signal generation module according to an embodiment of the present disclosure;
FIG. 2 is a timing diagram showing an execution timing of a control-signal generation method according to an embodiment of the present disclosure;
FIG. 3 is a timing diagram of a control-signal generation method where a maximum on-time is applied according to an embodiment of the present disclosure; and
FIG. 4 is a timing diagram of a control-signal generation method where a minimum on-time or a minimum off-time is applied according to an embodiment of the present disclosure.

### DETAILED DESCRIPTION

In the following description, the present disclosure is described with reference to the respective embodiments. However, those skilled in the art will appreciate that the various embodiments can be implemented without one or more specific details or in conjunction with other replacement and/or additional methods or components. In other cases, well-known structures or operations are not shown or described in detail to avoid obscuring the inventive aspects of the present disclosure. Similarly, for purposes of explanation, specific quantities and configurations are set forth in order to provide a comprehensive understanding of embodiments of the present disclosure. However, the present disclosure is not limited to these particular details.

In the present disclosure, the reference to "an embodiment" or "the embodiment" means that a particular feature, structure, or characteristic described in connection with the embodiment is included in at least one embodiment of the present disclosure. The phrase "in an embodiment" / "in one embodiment" appearing throughout the present disclosure does not necessarily all refer to the same embodiment.

It should be noted that the embodiments of the present invention describe the method steps in a specific order, but this is only for the purpose of illustrating the specific embodiments and not to limit the order of the steps. On the contrary, in different embodiments of the present invention, the order of the steps can be adjusted according to the actual needs.

In embodiments of the present disclosure, the control signal(s) refer mainly to PWM signal(s).

In embodiments of the present disclosure, the term "dead zone" refers to the time interval inserted during PWM output level inversion. This dead zone helps prevent both devices from being on at the same time due to issues with switching speed when one device is turned off and another is turned on. This can prevent situations where the next device is turned on before the previous device is fully turned off, which can increase the load and potentially cause short circuits or other damage, especially when the current is too high.

In embodiments of the present invention, the term "SET" refers to driving the actuation modules to output a high-level drive signal, and the term "CLEAR" refers to driving the actuation modules to pull down their output drive signals. By controlling the duration of SET and CLEAR, drive signals with a desired pulse width can be obtained. The term "SET event" refers to an event that can trigger the actuation modules to output a high level, and the term "CLEAR event" refers to an event that can trigger the actuation modules to pull down their output levels.

In order to achieve high-precision CLEAR and/or SET, thereby improving the accuracy of pulse width control and reducing control errors, the present disclosure provides a control-signal generation module and method.

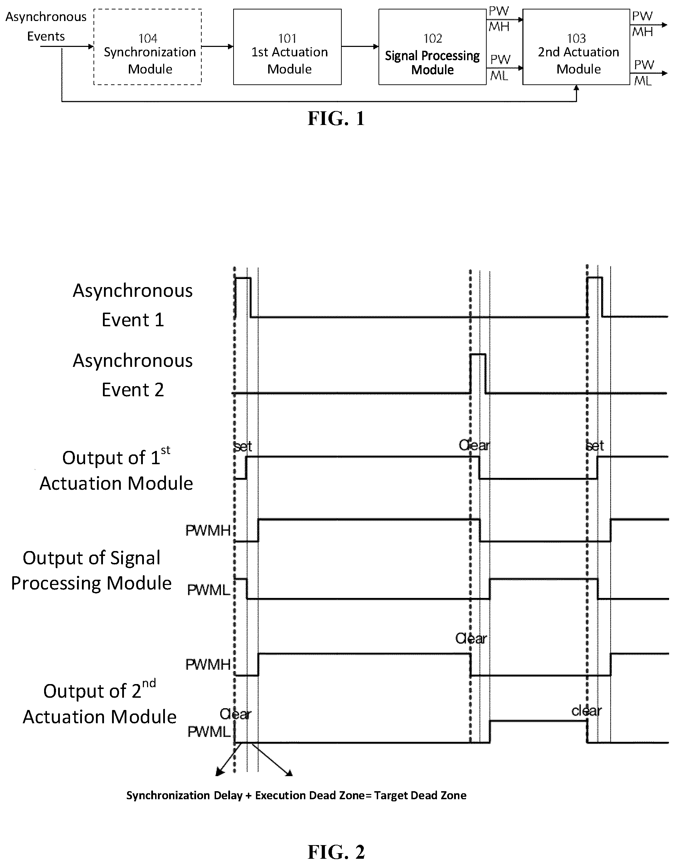

FIG. 1 is a block diagram of a control-signal generation module according to an embodiment of the present disclosure, where the dash box indicates optional components. As shown in FIG. 1, the control-signal generation module comprises a first actuation module 101, a signal processing module 102, and a second actuation module 103. The first actuation module 101 is edge-triggering, the second actuation module 103 is level-triggering, and the signal processing module 102 has an input terminal connected to an output terminal of the first actuation module 101, and an output terminal connected to an input terminal of the second actuation module 103.

The first actuation module 101 is edge-triggering, which means that it performs a corresponding operation, i.e., changes the output signal, when a valid edge of an event, such as a rising or falling edge, is received by the module, and the duration of the event has no effect on the first actuation module 101. In one embodiment of the present disclosure, asynchronous events are used to achieve high-precision SET or CLEAR, but the first actuation module needs to act according to valid edges of synchronized events, therefore, a synchronization module 104 can be added before the input terminal of the first actuation module 101, so that a synchronized event is obtained after synchronization of the asynchronous events (for example, synchronization with a clock), and then the synchronized event is input to the first actuation module 101; the generation of the synchronized event results in a synchronization delay. The first actuation module 101, upon receiving an valid edge of the synchronized asynchronous events, will change its output signal according to first preset information and output to the signal processing module, after which the signal processing module starts to output corresponding PWM signals to the second actuation module 103 according to preset configuration information, thus enabling the second actuation module 103 to remain off or output corresponding signals, thereby achieving high precision SET. In one embodiment of the present disclosure, the first actuation module can generate at least one PWM signal.

The second actuation module 103 is level-triggering, and it changes its output signal according to second preset information upon receiving a valid level of the asynchronous events. Since the second actuation module 103 is level-triggering, once the events disappear, it releases control of its output signals and no longer affects the final drive signal; so, in an embodiment of the present disclosure, when there is no valid level of the asynchronous events, the second actuation module 103 will output signals generated by the signal processing module 102. In an embodiment of the present disclosure, in order to maintain the driving state of the system, the asynchronous events have a valid level length greater than or equal to the length of time between a starting point of the asynchronous events and a time point when the signal processing module starts outputting updated signals. In an embodiment of the present disclosure, the path quantity of PWM signals generated by the second actuation module is not less than that of the first actuation module.

The signal processing module 102 is mainly used to process signals generated by the first actuation module and output the processed signals. In an embodiment of the present disclosure, the signal processing module directly outputs the signals generated by the first actuation module. In an embodiment of the present disclosure, the signal processing module comprises a delay sub-module, configured to determine an actual delay D_{cur} based on a preset delay Dₚᵣₑ, and to delay a rising edge or a falling edge of the output signal of the first actuation module by a length of the actual delay D_{cur}, and to generate corresponding PWM signals. In an embodiment of the present disclosure, the actual delay D_{cur} is equal to the difference between the preset delay Dₚᵣₑ and a synchronization delay D_{syn} due to synchronization of the asynchronous events, i.e., D_{cur}=Dₚᵣₑ-D_{syn}. With the delay sub-module, an accurate delay, i.e., an accurate target dead zone, can be obtained, thus enabling high-precision SET. In an embodiment of the present disclosure, the synchronization delay is less than or equal to the preset delay. In an embodiment of the present disclosure, the signal processing module further comprises an inverting sub-module configured to invert an output signal of the delay sub-module according to preset inverting information and to generate the corresponding PWM signals. In an embodiment of the present disclosure, the path quantity of control signals generated by the signal processing module is equal to that of PWM signals generated by the second actuation module, and not less than that of the first actuation module.

In an embodiment of the present disclosure, there are two types of PWM signals: PWMH signals and PWML signals, and a PWMH signal and a corresponding PWML signal are complementary signals. Therefore, high-precision SET and CLEAR of the PWMH signals and PWML signals can be achieved by two events. Therefore, in an embodiment of the present disclosure, the signal processing module and the second actuation module each output two paths of signals. The first actuation module may output one or two paths of signals. In the case where the first actuation module outputs only one path of signals to the signal processing module, a first event (asynchronous event 1) acts as a CLEAR event for the PWML signals, a SET event for the PWMH signal, and a SET event for the first actuation module, while a second event (asynchronous event 2) acts as a CLEAR event for the PWMH signals, a SET event for the PWML signal, and a CLEAR event for the first actuation module.

As described above, the control-signal generation module can generate a PWM driver that achieves high-precision SET with a rising-edge delay dead zone and high-precision CLEAR without a delay dead zone based on asynchronous events, or a PWM driver that achieves high-precision SET with a rising-edge dead zone based on asynchronous events and high-precision CLEAR based on synchronous events, or a PWM driver that achieves high-precision SET with a rising edge dead zone based on synchronous events and high-precision CLEAR without a delay dead zone based on asynchronous events.

Specifically, in one embodiment of the present disclosure, by means of the generation module as previously described or other suitable devices, control signals may be generated according to the following steps:

first, synchronizing asynchronous events by a synchronization module to obtain synchronized asynchronous events, then sending the synchronized asynchronous events to a first actuation module, and recording a synchronization delay due to the synchronization;

next, changing a PWM signal generated by the first actuation module in accordance with first preset information when the first actuation module receives a valid edge signal of the synchronized asynchronous events;

next, sending a PWM signal generated by the first actuation module to the signal processing module, and generating PWM signals by the signal processing module according to preset configuration information of the signal processing module, wherein the signal processing module comprises a delay sub-module, wherein the delay sub-module is configured to delay the PWM signal generated by the first actuation module by a length of an actual delay, wherein the actual delay is determined according to a preset delay and the synchronization delay, wherein the actual delay is equal to a difference between the preset delay and the synchronization delay, wherein the preset delay is not smaller than the synchronization delay; and

finally, sending the PWM signals generated by the signal processing module to the second actuation module, and directly outputting, by the second actuation module, the PWM signals generated by the signal processing module unless an event occurs that requires changing the PWM signals generated by the signal processing module, thereby realizing high-precision driving with adding a delay.

In an embodiment of the present disclosure, by means of the generation module of high-precision control signals as previously described or other suitable devices, control signals may also be generated according to the following steps:

first, by a second actuation module, after occurrence of asynchronous events, monitoring the asynchronous events, and changing PWM signals by the second actuation module in accordance with second preset information upon detecting a valid level of the asynchronous events, wherein the asynchronous events have an valid level length greater than or equal to the length of time between a starting point of the asynchronous events and a time point when the signal processing module starts outputting updated control signals;

at the same time, by a synchronization module, synchronizing the asynchronous events, and sending synchronized asynchronous events to a first actuation module; by the first actuation module, generating a PWM signal based on first preset information upon receiving a valid edge signal of the synchronized asynchronous events, and sending the PWM signal generated by the first actuation module to a signal processing module;

next, by the signal processing module, processing the PWM signal generated by the first actuation module in accordance with preset configuration information and outputting the processed PWM signal, for example, the signal processing module does not perform delay operations, and directly outputs the PWM signal generated by the first actuation module to the second actuation module;

finally, by the second actuation module, outputting PWM signals generated by the signal processing module when detecting disappearance of the valid level of the asynchronous events, thus achieving high-precision driving without a delay.

In order to protect the components and ensure reliable operation of the entire system, there need to be limits such as a maximum on-time and a minimum on/off-time for the driving output. Therefore, in one embodiment of the present disclosure, a preset maximum on-time is applied; specifically, the on-time, i.e., the duration for which the PWM signals generated by the second actuation module have a constant level, is continuously recorded, and the first actuation module is triggered to perform a preset action, such as changing the status of its outputs, when the duration of the on-time reaches the preset maximum on-time, at which time the signal processing module acts in accordance with the preset configuration information to change PWM signals to be generated by the signal processing module and sent to the second actuation module, causing the second actuation module to adjust the PWM signals to be generated by the second actuation module.

In another embodiment of the present disclosure, a minimum on/off-time is applied. Specifically, the minimum on/off-time can be implemented by actions of blocking valid events: when changes are detected in signals output by the second actuation module, the asynchronous events are blocked for a period of time, which is taken as the minimum on/off time; when the blocking ends, reception of the asynchronous events is resumed for driving control. In other words, the method further comprises ignoring valid events that occur during a period time whose length is equal to the preset minimum on/off time, which is counted from the time point when changes are detected in signals output by the second actuation module.

FIG. 2 is a timing diagram showing an execution timing of a high-precision control-signal generation method according to an embodiment of the present disclosure. In the embodiment shown in FIG. 2, two paths of complementary signals, PWMH and PWML, are generated, and the first actuation module outputs only one path of signal to the signal processing module; additionally, the events are asynchronous events, and specifically, the asynchronous event 1 acts as a SET event for the PWMH signals and a CLEAR event for the PWML signals, and the asynchronous event 2 acts as a SET event for PWML signals and a CLEAR event for PWMH signals. Also, the asynchronous event 1 acts as a SET event for the first actuation module to output, and the asynchronous event 2 acts as a CLEAR event for the first actuation module. Then, as shown in FIG. 2, the asynchronous event 1 is generated and goes directly to the second actuation module through an asynchronous path, and a preset action is executed after the occurrence of a clear asynchronous event, i.e., the second actuation module immediately shuts down its PWML signal, without affecting its PWMH signal. The second actuation module is a level-triggering actuation module, which releases control of the PWM signals when the asynchronous events disappear, and then no longer has impact on the final PWM signals. In order for the PWML signals to remain shut down, the asynchronous event 1 enters the first actuation module after synchronization, and upon detecting a valid edge the first actuation module changes the PWM output signal. The duration of the asynchronous event has no effect on the first actuation module. The first actuation module will then control the signal processing module to shut down the PWML signal of the signal processing module, thus rendering the PWML signal of the second actuation module to remain shut down. It should be noted that in order to achieve the above effect, the duration of the asynchronous event 1 needs to be greater than or equal to the synchronization delay. In addition, since the asynchronous event 1 is a SET event for the PWMH signals, after the first actuation module changes the PWM signal to be generated by it, the signal processing module adds an extra delay (i.e., execution dead zone) to the rising edge dead zone of its PWMH signal, which causes the expanded rising edge dead zone of the PWMH signal to reach a preset target dead zone, thus achieving a high-precision SET of its PWMH signal.

Similarly, when the asynchronous event 2 occurs, it goes directly to the second actuation module through an asynchronous path and a preset action is executed after the occurrence of the asynchronous event 2, i.e., the second actuation module immediately shuts down its PWMH signal, without affecting its PWML signal. In order for the PWMH signals to remain shut down, the asynchronous event 2 enters the first actuation module after synchronization, and upon detecting a valid edge of the asynchronous event, the first actuation module changes the PWM signal to be generated by it. The first actuation module will then control the signal processing module to shut down the PWMH signal of the signal processing module, thus rendering the PWMH signal of the second actuation module to remain shut down. It should be noted that in order to achieve the above effect, the duration of the asynchronous event 2 needs to be greater than or equal to the synchronization delay. In addition, since the asynchronous event 2 is a SET event for the PWML signals, after the first actuation module changes the PWM signal to be generated by it, the signal processing module adds an extra delay (i.e., execution dead zone) to the rising edge dead zone of its PWML signal, which causes the expanded rising edge dead zone to reach a preset target dead zone, thus achieving a high-precision SET of its PWML signal.

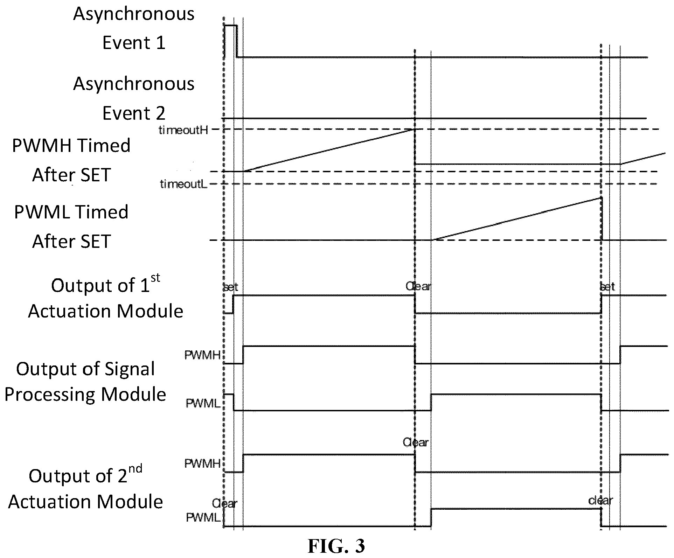

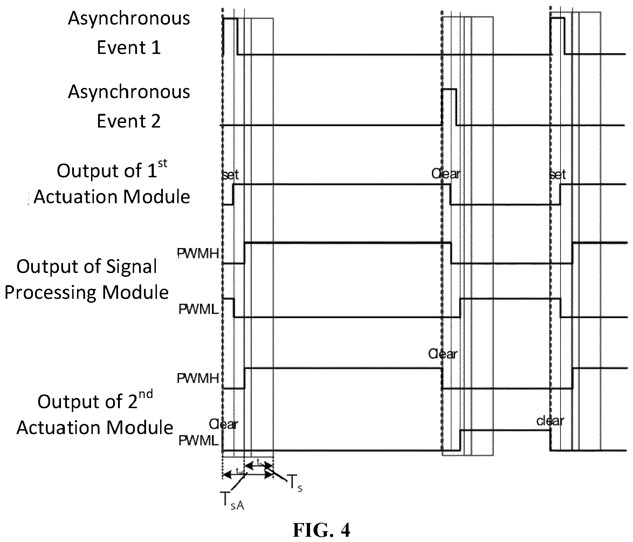

FIG. 3 and FIG. 4 are timing diagrams of a control-signal generation method where a maximum on-time, or a minimum on-/off-time is applied according to an embodiment of the present disclosure. As shown in FIG. 3, the PWMH signals and PWML signals are timed after SET, respectively, and once a timed duration reaches the preset maximum on-time, a corresponding event is generated to shut down the corresponding signal. In an example as shown in FIG. 4, wherein the PWMH signals and PWML signals are complementary signals, with a shield time less than a dead time; when the asynchronous event 1 occurs, the PWML signals are immediately shut down, at which time the driver changes and a shield-time function is activated, the PWMH signals are pulled up after the dead zone, at which time the preset shield time Ts has not been reached, but the PWMH signals have changed, meaning the shield time needs to be retimed until the end point of the shield time; the actual shield time is TsA.

The present disclosure can achieve high-precision drive pulses through asynchronous event control, and highly integrate power conversion control, such as peak control and hysteresis control, which relies on asynchronous event control to achieve digitalization, thereby improving the accuracy of pulse width control, reducing control errors, and adapting to the trend of higher system frequencies.

Embodiments described above are exemplary instead of restrictive of the present disclosure. It will be apparent to those skilled in the relevant field that various combinations, variations and changes can be made to the embodiments without departing from the spirit and scope of the present disclosure.

## Claims

1. A control-signal generation module, comprising:
a first actuation module, which is edge-triggering and configured to change its output signal in accordance with first preset information upon receiving a valid edge of asynchronous events that have been synchronized;
a second actuation module, which is level-triggering and configured to change its output signals in accordance with second preset information upon receiving a valid level of the asynchronous events; and
a signal processing module, whose input terminal is connected to an output terminal of the first actuation module and whose output terminal is connected to an input terminal of the second actuation module,
wherein the signal processing module is configured to process the output signal of the first actuation module according to preset configuration information and output the processed output signal,
wherein when the second actuation module no longer receives the valid level of the asynchronous events, the second actuation module outputs signals generated by the signal processing module.

2. The generation module as claimed in claim 1, wherein the signal processing module comprises a delay sub-module configured to determine an actual delay Dcur based on a preset delay Dpre, and to delay a rising edge or a falling edge of the output signal of the first actuation module by a length of the actual delay Dcur, and to generate corresponding PWM signals,
wherein Dcur=Dpre-Dsyn, wherein Dsyn is a synchronization delay due to synchronization of the asynchronous events, and is smaller than or equal to the preset delay.

3. The generation module as claimed in claim 1 or 2, wherein the signal processing module is configured to directly output the output signal of the first actuation module without processing.

4. The generating module as claimed in claim 2, wherein the signal processing module further comprises an inverting sub-module configured to invert an output signal of the delay sub-module according to preset inverting information and to generate the corresponding PWM signals.

5. The generation module as claimed in claim 1, wherein the asynchronous events have a valid level length greater than or equal to the length of time between a starting point of the asynchronous events and a time point when the signal processing module starts outputting updated signals.

6. The generation module as claimed in claim 1, further comprising a synchronization module configured to synchronize the asynchronous events and then output them to the first actuation module.

7. The generation module as claimed in claim 1, wherein
the first actuation module is configured to generate at least one path of PWM signals; and
a path quantity of PWM signals generated by the second actuation module is equal to that of the signal processing module, and is not less than that of the first actuation module.

8. A control-signal generation method, comprising:
synchronizing asynchronous events by a synchronization module to obtain synchronized asynchronous events, then sending the synchronized asynchronous events to a first actuation module, and recording a synchronization delay due to the synchronization;
generating a first PWM signal by the first actuation module in accordance with first preset information when the first actuation module receives a valid edge signal of the synchronized asynchronous events;
sending the first PWM signal generated by the first actuation module to a signal processing module, and generating updated PWM signals by the signal processing module according to preset configuration information of the signal processing module, wherein the signal processing module comprises a delay sub-module, wherein the delay sub-module is configured to delay the first PWM signal generated by the first actuation module by a length of an actual delay, wherein the actual delay is determined according to a preset delay and the synchronization delay; and
sending the updated PWM signals generated by the signal processing module to the second actuation module, and directly outputting, by the second actuation module, the updated PWM signals generated by the signal processing module unless an event occurs to the second actuation module that requires changing the updated PWM signals generated by the signal processing module.

9. The generation method as claimed in claim 8, wherein the actual delay is equal to a difference between the preset delay and the synchronization delay, wherein the preset delay is not smaller than the synchronization delay.

10. A control-signal generation method, comprising:
by a second actuation module, after occurrence of asynchronous events, monitoring the asynchronous events, and changing PWM signals to be generated by the second actuation module in accordance with second preset information upon detecting a valid level of the asynchronous events;
by a synchronization module, synchronizing the asynchronous events, and sending synchronized asynchronous events to a first actuation module; by the first actuation module, changing a PWM signal to be generated by the first actuation module in accordance with first preset information upon receiving a valid edge signal of the synchronized asynchronous events, and sending a PWM signal generated by the first actuation module to a signal processing module;
by the signal processing module, processing the PWM signal generated by the first actuation module in accordance with preset configuration information and outputting the processed PWM signal; and
by the second actuation module, outputting PWM signals generated by the signal processing module when detecting disappearance of the valid level of the asynchronous events.

11. The generation method as claimed in claim 10, wherein the asynchronous events have a valid level length greater than or equal to the length of time between a starting point of the asynchronous events and a time point when the signal processing module starts outputting the updated PWM signals that it generates.

12. The generation method as claimed in claim 8 or 10, further comprising:
when PWM signals generated by the second actuation module have a constant level for a duration longer than a preset maximum on-time, triggering the first actuation module to change a status of its outputs, at which time the signal processing module acts in accordance with the preset configuration information to change PWM signals to be generated by the signal processing module, causing the second actuation module to adjust the PWM signals to be generated by the second actuation module.
